# EUROPEAN PATENT SPECIFICATION

(11) **EP 2 351 039 B1**
(45) Date of publication and mention of the grant of the patent: **30.12.2020**
(21) Application number: 09840565.7
(22) Date of filing: 23.09.2009
(51) Int. Cl.: G11C 11/56, G11C 16/06, G11C 16/10

(54) **DATA PATH FOR MULTI-LEVEL CELL MEMORY, METHODS FOR STORING AND METHODS FOR UTILIZING A MEMORY ARRAY**
DATENPFAD FÜR EINEN MEHRSTUFIGEN ZELLENSPEICHER, SPEICHERVERFAHREN UND VERWENDUNGSVERFAHREN FÜR EIN SPEICHERARRAY
TRAJET DE DONNÉES DESTINÉ À UNE CELLULE DE MÉMOIRE À PLUSIEURS NIVEAUX, PROCÉDÉ DE MÉMORISATION ET PROCÉDÉS D' UTILISATION D' UN RÉSEAU DE MÉMOIRE

(30) Priority: 30.10.2008 US 261928
(43) Date of publication of application: 03.08.2011
(73) Proprietor: Micron Technology, Inc., Boise, ID 83716-9632 (US)
(72) Inventor: BAUER, Mark, Folsom California 95630 (US)
(74) Representative: Small, Gary James
(86) International application number: PCT/US2009/058053
(87) International publication number: WO 2010/096099

(56) References cited:
- EP-A1- 1 298 670
- US-A1- 2005 219 077
- US-A1- 2005 273 549
- US-A1- 2007 171 714
- US-A1- 2007 195 597
- US-A1- 2007 195 597
- US-B1- 6 532 556
- US-B1- 6 532 556

## Description

### TECHNICAL FIELD

Embodiments of the present invention relate generally to semiconductor memory and specifically, in one or more of the illustrated embodiments, to semiconductor memory having a data path for storing more than one binary digit of digital information per memory cell.

### BACKGROUND OF THE INVENTION

Each memory cell of a semiconductor memory system, such as a memory device, has traditionally been used to store one binary digit ("bit") of digital information. In order to store large amounts of digital information large arrays of memory cells are used. One challenge that is presented by the traditional approach of one bit per cell is to continually shrink the size of the memory array in order to increase the capacity of the memory without dramatically increasing the overall size of the memory system. Example approaches to reduce the size of the array have been to design memory cells that occupy less area and reducing the distance between the memory cells in order to increase memory cell density and capacity. As the feature size of the memory cells becomes smaller, however, the complexity of fabricating the memory increases resulting in increased cost of manufacturing.

A relatively recent approach to increasing memory capacity has been to design memory cells and supporting circuitry for storing multiple bits of digital information in each memory cell. For example, rather than store one bit of digital information, as has been the tradition, two bits of digital information are stored by a memory cell. Storage of two bits of digital information is accomplished by having memory cells and read/write circuitry that can accurately store, read, and write four distinct memory states. Each of the four memory states represents a different combination of two bits of information, that is, 00, 01, 10, and 11. In contrast, the traditional one bit per cell approach requires memory cells and read/write circuitry that can accurately store, read, and write two distinct memory states, each distinct memory state representing either a 0 or 1. Use of memory cells for storing more than two memory states may be applicable for different types of memory, for example, in both volatile (e.g., DRAM) and non-volatile memory (e.g., flash memory).

Projecting forward along the current trajectory of using memory cells for storing more than two memory states, starting with using two different memory states for storing one bit of digital information and evolving to using four different memory states for storing two bits of digital information, three bits of digital information may be stored by using eight different memory states and four bits of digital information may be stored by using sixteen different memory states. As illustrated by this example, the number of memory states per memory cell is a power-of-two, and the resulting number of bits stored per cell is the base two logarithm of the number of memory states.

A challenge with designing memory systems along this trajectory is the difficulty of reliably and accurately storing, reading, and writing, for example, twice as many memory states as the previous iteration. Evolving from storing, reading and writing two memory states to storing, reading and writing four memory states presented difficulties that were eventually overcome. Evolving from using four memory states to using eight memory states, however, presents challenges that are much more difficult with the current state of technology than those presented in the previous evolution of two memory states to four memory states. Although the difficulties are not insurmountable and will eventually be overcome, it is desirable to have, for example, memory systems utilizing memory cells for storing multiple memory states to provide a storage density of greater than one bit per cell without being limited to storing a power-of-two number of memory states.

European Patent Application EP1298670 describes a method for storing and reading data in a multilevel non-volatile memory with a non-binary number of levels, and architecture therefor. According to the multilevel programming method, each memory location can be programmed at a non-binary number of levels. An integer number of bits, for example 5, is stored in two adjacent memory locations. To this end, the bits to be stored in the two locations are divided into two sets, wherein the first set defines a binary number of levels higher than the non-binary number of levels. During programming, if the first set of bits to be written corresponds to a number smaller than the non-binary number of levels, the first set of bits is written in the first location and the second set of bits is written in the second location; if, instead, it is greater than the non-binary number of levels, the first set of bits is written in the second location and the second set of bits is written in the first location.

US Patent Application US2005/219077 describes fractional-bit systems. The disclosed invention abandons the conventional approach of incrementing bits-per-cell b by 1, but allows increments of states-per-cell N by as little as 1 between product generations. Because N is no longer an integral power of 2, b takes a fractional value, resulting in a fractional-bit system. In a fractional-bit system, cells are decoded in unit of word. By adjusting the word-width, the system efficiency can be optimized.

US 6,532,556 B1 discloses data management for multi-bit-per-cell memories. Therein is disclosed a multi-bit-per-cell memory employing a data management process that partitions an input bit sequence from an input serial data stream into groups of M bits. M is an integer multiple of N, and N is the number of bits stored per cell in a storage array. A register stores an M-bit group from the input serial data stream. An M-bit scrambler mixes or scrambles the bits in each original M-bit group from register to generate a scrambled M-bit group. The scrambled M-bit group includes (M/N) scrambled N-bit values that are input to a write circuit including translators. Translators translate each scrambled N-bit value into one of the 2^{N} levels for writing into a corresponding one of the multi-level memory cells.

The scope of the invention is defined in the appended claims. Any reference to "embodiment(s)", "example(s)" or "aspect(s) of the invention" in this description not falling under the scope of the claims should be interpreted as illustrative example(s) for understanding the invention.

### BRIEF DESCRIPTION OF THE DRAWINGS

Figure 1 is a block diagram of a data path according to an embodiment of the present invention.
Figure 2A is a block diagram of a data path having a bit mapping and data conversion circuit 130 according to an embodiment of the present invention. Figure 2B is a table of resulting bit/cell storage densities related to using pairs of multi-level memory cells of a memory array having non-power-of-two number of memory states.
Figure 3 are truth tables for storing binary user data using pairs of multi-level memory cells having six memory states according to an embodiment of the invention.
Figure 4 are truth tables for storing binary user data using pairs of multi-level memory cells having three memory states according to an embodiment of the invention.
Figure 5 is a block diagram of a data path according to an embodiment of the present invention for storing data using pairs of multi-level memory cells having six memory states.
Figure 6 is a block diagram of a data path according to another embodiment of the present invention for storing data using pairs of multi-level memory cells having three memory states.
Figure 7 is a block diagram of a data path according to another embodiment of the present invention for storing data using pairs of multi-level memory cells having four memory states.
Figure 8 is a block diagram of a memory system having a data path according to an embodiment of the present invention.

### DETAILED DESCRIPTION

Certain details are set forth below to provide a sufficient understanding of embodiments of the invention. However, it will be clear to one skilled in the art that embodiments of the invention may be practiced without these particular details. Moreover, the particular embodiments of the present invention described herein are provided by way of example and should not be used to limit the scope of the invention to these particular embodiments. In other instances, well-known circuits, control signals, timing protocols, and software operations have not been shown in detail in order to avoid unnecessarily obscuring the invention.

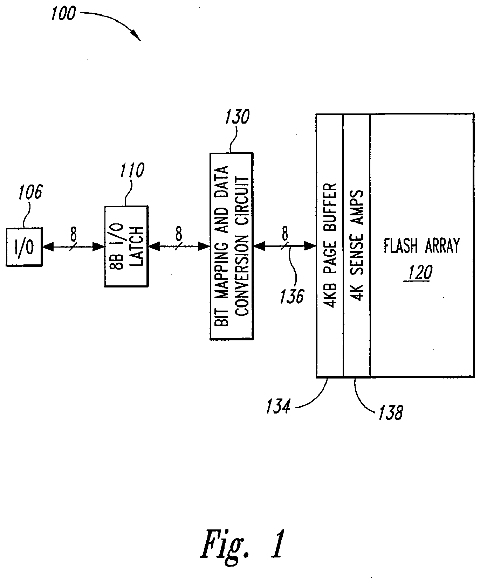

Figure 1 illustrates a data path 100 according to an embodiment of the present invention. The data path 100 couples data applied to input/output (I/O) nodes, such as terminals 106 to a flash memory array 120 to write data and couples data from the flash memory array 120 to the I/O terminals 106 to provide read data. The memory array 120 includes multi-level memory cells that store P different memory cell states, where P can be a non-power-of-two number. The data path 100 includes an I/O latch 110 coupled to I/O terminals 106 to latch binary digits (i.e., "bits") of information. In the embodiment illustrated in Figure 1, the I/O latch 106 is 8-bits wide, and the I/O terminals 106 represent eight I/O terminals. A bit mapping and data conversion circuit 130 according to an embodiment of the present invention is coupled to the latch 110. The bit mapping and data conversion circuit 130, as will be described in more detail below, is configured to enable the memory array 120 to store N bits/cell, where N can be a non-integer number. The bit mapping and data conversion circuit 130 is coupled through a data bus 136 (shown in Figure 1 as 8-bits wide) to a page buffer 134, which is in turn coupled to sense amplifiers 138 and the flash memory array 120. The data path 100 is similar to a conventional data path, except for including a bit mapping and data conversion circuit coupled between the I/O latch 110 and the buffer 134. In the embodiment illustrated in Figure 1, the page buffer can store 4 kBits (4,096 bits) and the sense amplifiers 138 include 4 k sense amplifiers. The particular bit-dimensions provided for the data path 100 are provided by way of example, and other embodiments of the invention include components having different bit-dimensions.

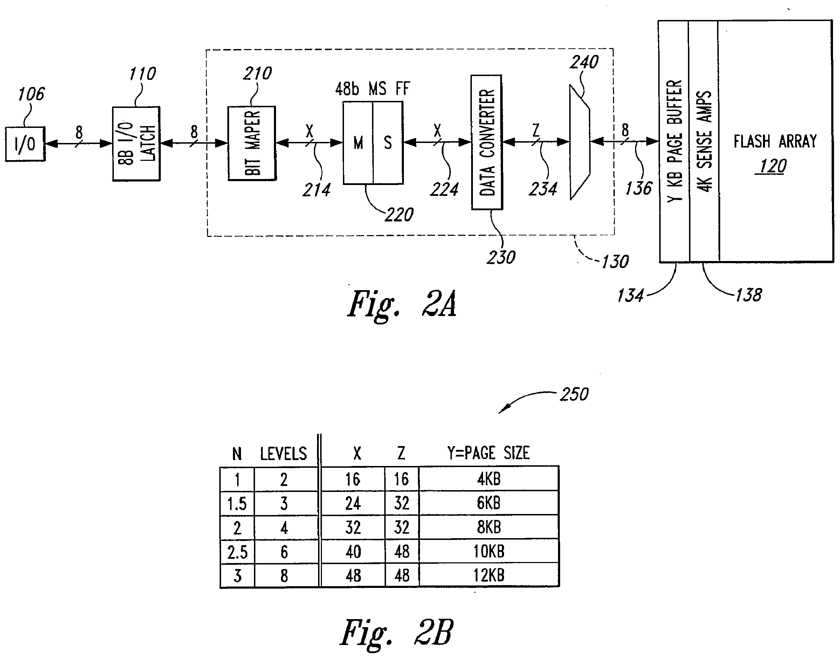

Figure 2A illustrates the data path 100 having a bit mapping and data conversion circuit 130 according to an embodiment of the invention. The bit mapping and data conversion circuit 130 includes a bit mapping circuit 210 coupled through a bus 214 to a register 220 for mapping bits of data from the I/O latch 110 to the register 220, and vice versa. A data converter 230 coupled to the register 220 through bus 224 converts data bits into intermediate binary data (IBD) that is provided over bus 234 to be written to the page buffer 134 through a multiplexer 240. The data converter 230 further converts IBD read from the page buffer 134 into data to be stored in the register 220 to then be provided through the bit mapping circuit 210 to the latch 110. The multiplexer 240 routes the IBD between the bus 234 and the bus 136, which may have different bit-widths. In the embodiment of the invention illustrated in Figure 2A, the I/O latch is 8-bits wide, and the bus 136 is also 8-bits wide. However, in other embodiments, the bit-widths of the busses can be different.

In operation, the bit mapping and data conversion circuit 130 can be configured to convert binary user data to IBD, and vice versa. The IBD is intermediate binary data that can be stored as a memory cell state in a memory cell of the memory array 120. As previously mentioned, the bit mapping and data conversion circuit 130 can be used to enable binary user data to be stored using groups of multi-level memory cells capable of storing non-power-of-two memory states to effectively store a non-integer number of bits-per-cell. The storage of binary user data using groups of memory cells having non-power-of-two states to provide a non-integer number of bits-per-cell is transparent to a user, who can write and read binary data in conventional byte and word lengths.

Examples of different configurations of the bit mapping and data conversion circuit 130 are shown in table 250 of Figure 2B, which are provided as non-limiting examples. The example configurations shown in table 250 result from utilizing groups of two memory cells and provide a respective bits-per-cell storage density for the corresponding number of memory states storable by memory cells in the array. For example, assuming groups of two memory cells, the bit mapping and data conversion circuit 130 can be configured to provide a storage density of 2.5 bits/cell when used with memory cells having six storable memory states. In another configuration, the bit mapping and data conversion circuit 130 can provide a storage density of 2 bits/cell when used with memory cells having four storable memory states. As illustrated by the latter example, the bit mapping and data conversion circuit 130 can also be used with memory cells having typical power-of-two storable memory states to provide typical bits-per-cell storage densities.

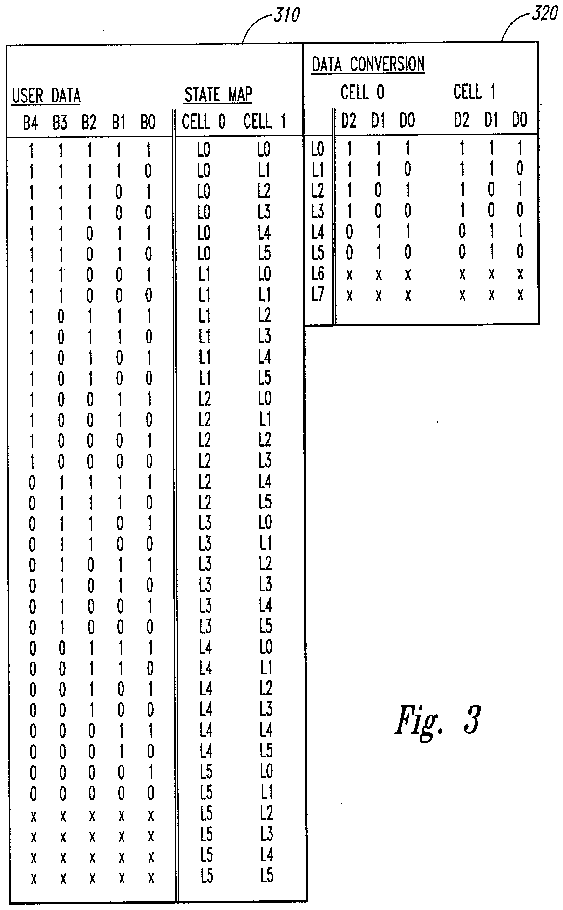

Figure 3 illustrates tables 310 and 320 for converting between binary user data and IBD stored by groups of two memory cells, each having six memory states, according to an embodiment of the invention. As previously discussed with reference to Figure 2 and table 250, in an embodiment utilizing memory cells having six storable memory states (L0-L5) and using a group of two memory cells (CellO and Cell1), a storage density of 2.5 bits/cell is achieved. Table 310 illustrates assignment of combinations of the six memory states (L0-L5) of the two memory cells to 5-bit values of binary user data. As will be described in more detail below, a user's 8-bit data (i.e., 1 byte) is divided into 5-bit binary data that is converted into IBD by the data converter 230. The IBD is then stored in a pair of memory cells. Table 320 illustrates the conversion between the IBD and the memory states for the individual cells of the pair.

For example, where the 8-bit binary user data is 01011101 (B7:B0) and is to be written to memory, the user data is split into first 5-bit binary data, with the remaining 3-bits to be part of another 5-bit binary data. In the particular example, the first 5-bit binary data (B4:B0) is 11101 and the remaining 3-bits 010 (B7:B5) will be joined with five other bits from other 8-bit binary user data. Turning to the 5-bit binary data 11101 (B4:B0) and table 310, the binary data corresponds to a combination of memory cell states L0 and L2 stored by a pair of multilevel memory cells Cell0 and Cell1, respectively. As will be described in more detail below, in determining the memory state to be stored by the respective memory cell, the 5-bit binary data is converted into two 3-bit IBDs, which are each in turn stored as a corresponding memory state in a respective memory cell according to table 320.

In reading data from memory, a pair of cells are accessed and the respective memory states are conventionally sensed for memory cells having six memory states to provide corresponding 3-bit IBDs for each memory cell. For example, reading memory cell states L0 and L2 stored by memory cells Cell0 and Cell1, respectively, the two memory cells are accessed and memory states L0 and L2 result in two 3-bit IBDs of 111 and 101. The 3-bit IBDs are converted back into 5-bit binary data. According to table 310, the resulting 5-bit data is 11101, which is the original 5-bit binary data from the previous example of writing data to memory. The 5-bit binary data is then concatenated to other 5-bit binary data read from the memory and split into the original 8-bit binary user data.

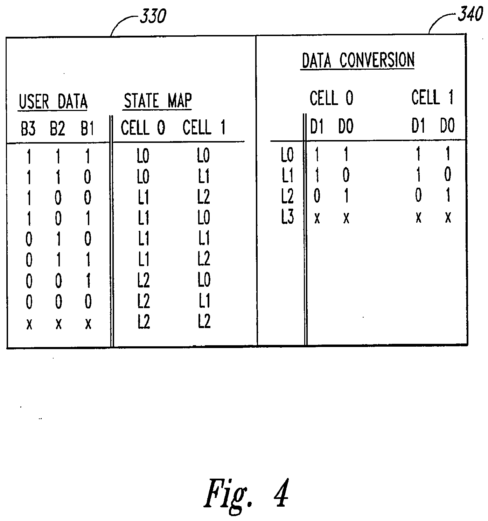

Figure 4 illustrates tables 330 and 340 for converting between binary user data and IBDs stored by groups of two memory cells, each having three memory states, according to an embodiment of the invention. As previously discussed with reference to Figure 2 and table 250, in an embodiment utilizing memory cells having three storable memory states (L0-L2) and using a group of two memory cells (Cell0 and Cell1), a storage density of 1.5 bits/cell is achieved. Table 330 illustrates assignment of combinations of the three memory states (L0-L2) of the two memory cells to 3-bit values of binary user data. As will be described in more detail below, a user's 8-bit data is divided into 3-bit binary data that is converted into IBD by the data converter 230. The IBD is then stored in a pair of memory cells. Table 340 illustrates the conversion between the IBD and the memory states for the individual cells of the pair.

For example, where the 8-bit binary user data is 01011101 (B7:B0) and is to be written to memory, the user data is split into first and second 3-bit binary data (B2:B0) and (B5:B3), with the remaining 2-bits (B7:B6) to be part of another 3-bit binary data. In the particular example, the first 3-bit binary data is 101, the second 3-bit binary data is 011, and the remaining 2-bits 01 will be joined with one other bit from other 8-bit binary user data. Turning to the two 3-bit binary data 101 and 011, and table 330, the first binary data 101 corresponds to a combination of memory cell states L1 and L0 stored by a first pair of multilevel memory cells Cell0 and Cell1, respectively. The second binary data 011 corresponds to a combination of memory cell states L1 and L2 stored by a second pair of multilevel memory cells Cell0 and Cell1, respectively. As will be described in more detail below, in determining the memory state to be stored by the respective memory cell, the 3-bit binary data is converted into two 2-bit IBDs, which are each in turn stored as a corresponding memory state in a respective memory cell.

In reading data from memory, a pair of cells are accessed and the respective memory states are conventionally sensed for memory cells having three memory states to provide corresponding 2-bit IBDs for each memory cell. For example, taking memory cell states L1 and L0 stored by the first pair of memory cells Cell0 and Cell1, respectively, the two memory cells are accessed and memory states L1 and L0 result in two IBDs of 10 and 11. Memory cell states L1 and L2 stored by a second pair of multilevel memory cells Cell0 and Cell1, respectively, the two memory cells are accessed and memory states L1 and L2 result in two IBDs of 10 and 01. The 2-bit IBDs are converted back into 3-bit binary data. In the present example, the resulting 3-bit binary data for the first pair of memory cells is 101 and the resulting 3-bit binary data for the second pair of memory cells is 011, in accordance with table 330, which are the original 3-bit data from the previous example of writing data to memory. The 3-bit binary data is then concatenated to other 3-bit binary data read from the memory and split into the original 8-bit binary user data.

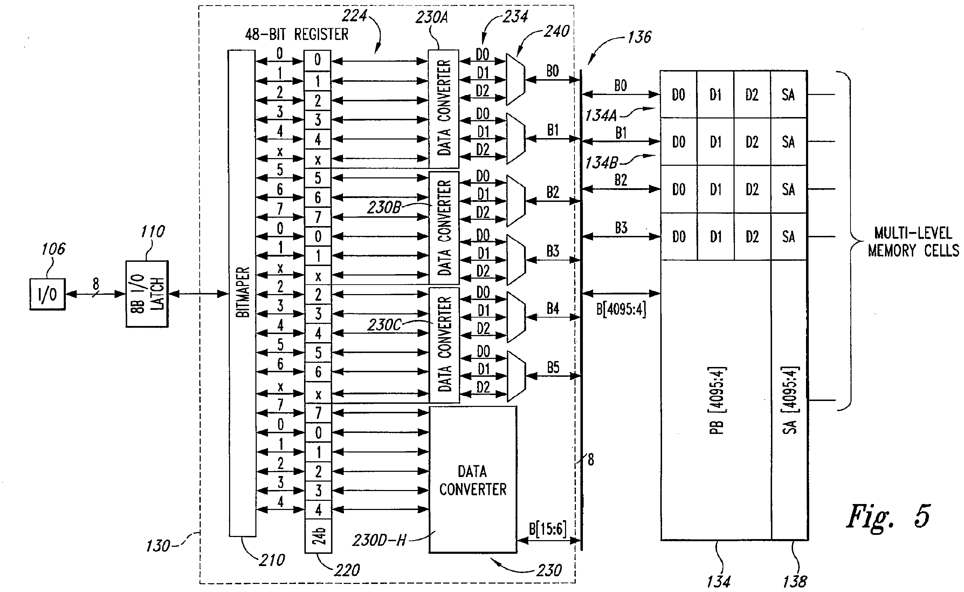

Figure 5 illustrates the data path 100 having a bit mapping and data conversion circuit 130 according to an embodiment of the present invention. The data path 100 of Figure 5 can be used to implement the six memory state, two cell example previously discussed with reference to Figure 3. The embodiment of the invention shown in Figure 5 includes an 8-bit input/output latch coupled through a bit mapping circuit 210 to a 48-bit register 220. The 48-bit register 220 provides binary data to eight data converter subcircuits 230A-H that convert the binary user data into IBDs, which are written to a multi-level memory cell array through multiplexers 240, data bus 136 and a buffer 134. Sense amplifiers 138 convert between memory states stored by the multi-level memory cells and IBDs stored in the page buffer 134.

In operation, 8-bit user data loaded in the latch 110 is sequentially provided to the bit mapping circuit 210 to have the bits of the user data mapped to corresponding locations of the register 220. In the embodiment shown in Figure 5, the 8-bit user data is mapped through the bit mapping circuit 210 until the appropriate number of bits of user data are loaded into the register 220. In the present example of six memory states and two cells, the 8-bit user data is split into 5-bit binary data, as previously discussed. The 5-bit binary data stored in the register 220 are provided to data converter subcircuits 230A-H to be converted into pairs of 3-bit IBDs, which are in turn converted into memory states stored in respective memory cells.

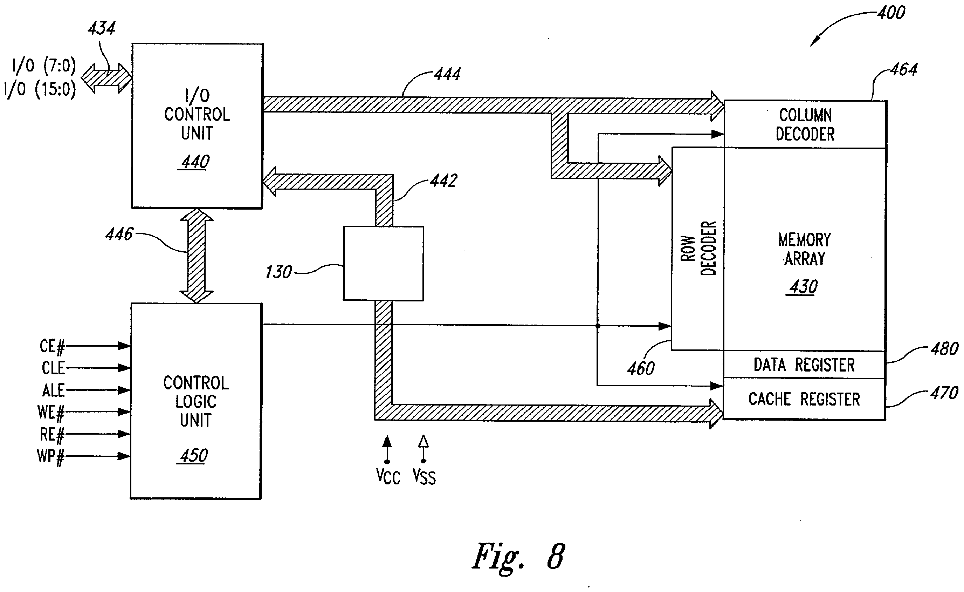

For example, using the previously described example with reference to Figure 3, 8-bit binary user data 01011101 (B7:B0) is loaded into the latch 110 to be mapped through bit mapping circuit 210 into register 220. In the embodiment shown in Figure 5, bits 11101 (B4:B0) would be mapped to five of six bit register locations of the register 220 that are coupled to data converter subcircuit 230A and bits 010 (B7:B5) would be mapped to three of six bit register locations of the register 220 that are coupled to data converter subcircuit 230B. 8-bit binary user data continues to be loaded through the bit mapping circuit 210 until the register 220 is loaded. In the example of splitting the 8-bit user data into 5-bit binary data, five 8-bit bytes of user data can be loaded in the 48-bit register 220 until the its capacity is reached. The data converter subcircuits 230A-H convert the 5-bit binary data into 3-bit IBDs, as previously discussed. With reference to table 310 of Figure 3, the 5-bit data 11101 of the particular example is converted by data converter subcircuit 230A into 3-bit IBDs 111 and 101, which are provided over bus 234 to be loaded bit-by-bit through multiplexer 240 and data bus 136 to locations 134A and 134B in the page buffer 134. The other 5-bit binary data stored in the register 220 are similarly converted into respective pairs of 3-bit IBDs by the data converter subcircuits 230B-H and loaded through the bus 234, mutliplexer 240, and data bus 136 into the page buffer 134.

After the page buffer 134 is loaded with the IBDs, sense amplifiers 138 convert the respective 3-bit IBD into a corresponding memory state to be stored in a respective multi-level memory cell. Sense amplifiers for converting the IBDs into a corresponding memory state is known in the art, and sense amplifiers of conventional design can be used for the sense amplifiers 138. In the present example, the 3-bit IBD 111 corresponds to memory state L0 (with reference to table 320 of Figure 3) and is stored in a first memory cell CellO of a pair of memory cells Cell0, Cell1 (not shown) used to store the 5-bit binary data. The 3-bit IBD 101 corresponds to L2 and is stored in a second memory cell Cell1.

When reading data from the multi-level memory cells, the process of writing data to the multi-level memory cells is generally reversed. That is, the memory states stored by multi-level memory cells are sensed by sense amplifiers 138 and converted into 3-bit IBDs that are stored in respective locations in the page buffer 134. The IBDs from pairs of memory cells are coupled to the respective data converter subcircuit, for example, IBDs stored by locations 134A, 134B are coupled through the data bus 136, multiplexers 240 and bus 234 to the data converter subcircuit 230A. The two 3-bit IBDs are converted by the data converters 230 into corresponding 5-bit binary data that is stored in appropriate bit locations in register 220. The bit mapping circuit 210 maps the 5-bit binary data into 8-bit data to reconstruct the original 8-bit binary user data.

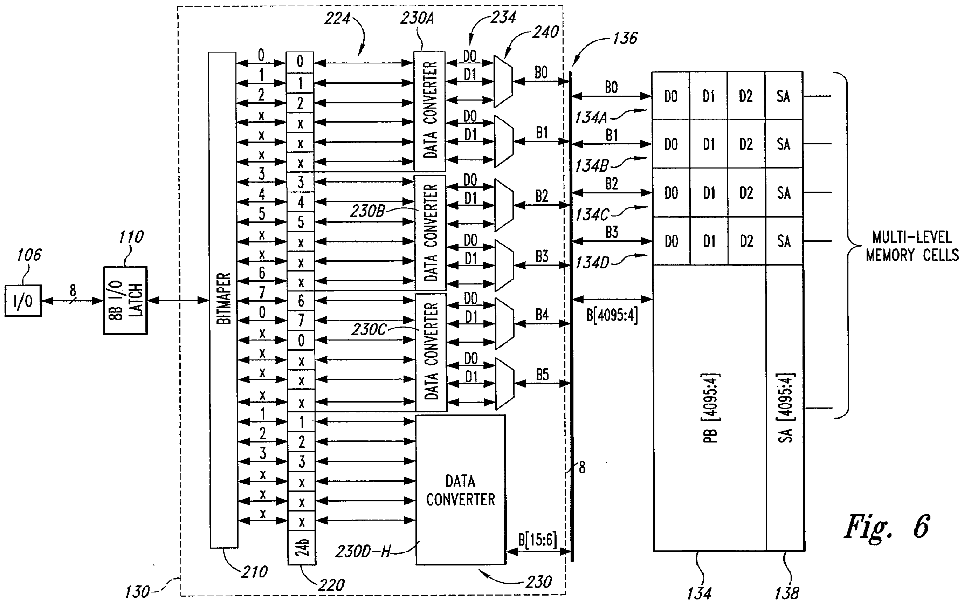

Figure 6 illustrates the data path 100 previously described with reference to Figure 5 having the bit mapping and data conversion circuit 130 configured implement the three memory state, two cell example previously discussed with reference to Figure 4. That is, in some embodiments of the invention, the data path 100 can be configured to implement different bit/cell storage densities in a memory having multi-level memory cells, including multi-level memory cells capable of storing non-power-of-two memory states and bit/cell storage densities that are non-integer numbers.

In operation, 8-bit binary user data loaded in the latch 110 is sequentially provided to the bit mapping circuit 210 to have the bits of the user data mapped to corresponding locations of the register 220. In the embodiment shown in Figure 6, the 8-bit user data is mapped through the bit mapping circuit 210 into 3-bit binary data, as previously discussed with reference to Figure 4, which are stored in the register 220. The 3-bit binary data stored in the register 220 are provided to data converter subcircuits 230A-H to be converted into pairs of 2-bit IBDs, which are in turn converted into memory states stored in respective memory cells.

For example, using the previously described example with reference to Figure 4, 8-bit binary user data 01011101 (B7:B0) is loaded into the latch 110 to be mapped through bit mapping circuit 210 into register 220. In the embodiment shown in Figure 6, bits 101 (first 3-bits B2:B0) are mapped to three of six bit register locations coupled to data converter subcircuit 230A and bits 011 (second 3-bits B5:B3) are mapped to three of six bit register locations coupled to data converter subcircuit 230B. The remaining bits 01 (B7:B6) are mapped to two of six bits register locations coupled to data converter subcircuit 230C, which will be concatenated to 1-bit of the next 8-bit user data loaded into the latch 110. 8-bit binary user data continues to be loaded through the bit mapping circuit 210 until the register 220 is loaded. In the example of splitting the 8-bit user data into 3-bit binary data, three 8-bit bytes of user data can be loaded in the 48-bit register 220 until the its capacity is reached. The data converter subcircuits 230A-H convert the 3-bit binary data into 2-bit IBDs, as previously discussed with reference to table 340 of Figure 4. The first 3-bit data 101 is converted by data converter subcircuit 230A into 2-bit IBDs 10 and 11, which are provided over bus 234 to be loaded bit-by-bit through multiplexer 240 and data bus 136 to locations 134A and 134B in the page buffer 134. The second 3-bit data 011 is converted by data converter subcircuit 230B into 2-bit IBDs 10 and 01, which are provided over bus 234 to be loaded bit-by-bit through multiplexer 240 and data bus 136 to locations 134C and 134D in the page buffer 134.

When reading data from the multi-level memory cells, the memory states stored by multi-level memory cells are sensed by sense amplifiers 138 and converted into 2-bit IBDs that are stored in respective locations in the page buffer 134. The IBDs from pairs of memory cells are coupled to the respective data converter subcircuit, for example, IBDs stored by locations 134A, 134B and IBDs stored by locations 134C, 134D are coupled through the data bus 136, multiplexers 240 and bus 234 to the data converter subcircuit 230A and 230B, respectively. The pairs of 2-bit IBDs are converted into corresponding 3-bit binary data, which are stored in appropriate bit locations in register 220. The bit mapping circuit 210 maps the 3-bit binary data into 8-bit data to reconstruct the original 8-bit user data.

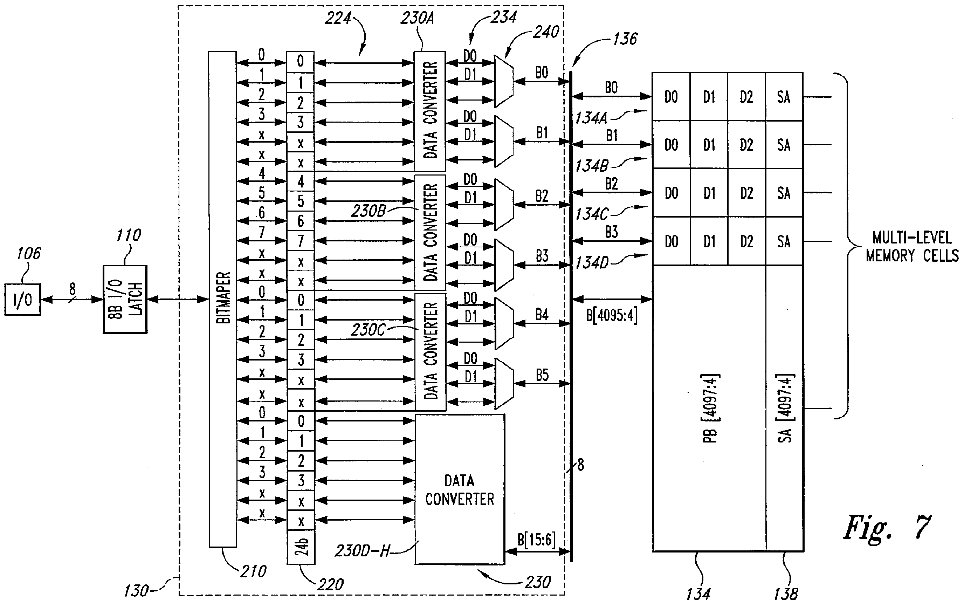

Figure 7 illustrates the data path 100 previously described with reference to Figure 5 having the bit mapping and data conversion circuit 130 configured implement a four memory state, two cell example to provide a bit/cell storage density of 2 bits/cell. As previously described with reference to Figures 5 and 6, the data 100 can be used for memories having multi-level memory cells capable of storing non-power-of-two memory states to provide bit/cell storage densities that are non-integer numbers. As shown in the embodiment of Figure 7, the data conversion circuit 130 can also be configured to work with multi-level memory cells capable of storing power-of-two memory states to provide an integer number of bit/cell storage density. Operation of the embodiment illustrated in Figure 7 is similar to that previously described with reference to Figures 5 and 6. In summary, the 8-bit user data is split into 4-bit binary data mapped to four of six bit register locations coupled to a respective data converter subcircuit 230. The 4-bit binary data is converted by the respective data converter subcircuit into two 2-bit IBDs. Each of the 2-bit IBDs are provided to the page buffer 134 and converted by the sense amplifiers 138 into a corresponding memory state to be stored in the memory array. Reading data is essentially the reverse of writing data to the memory array.

A truth table for the mapping of binary user data and conversion to IBDs, and then to corresponding memory states for the four memory state, two memory cell example of Figure 7, has not been provided herein, in the interest of brevity because such truth tables can be conventional. For example, each of the four memory states can correspond to a different 2-bit IBD (00, 01, 10, 11). Using a pair of memory cells, each memory cell having four memory states, sixteen different 4-bit combinations can be made. Each of the different 16-bit combinations can be represented by a different combination two 2-bit IBDs. As previously discussed, the resulting storage density is 2 bits/cell.

One or more Embodiments of the present invention can also have a bit mapping and data conversion circuit 130 configurable for use with different combinations of memory states to provide different bit/cell storage densities. In one embodiment, configuration of such a bit mapping and data conversion circuit can be reconfigured by user. For example, with reference to Figures 2A and 2B, given an N bits/cell storage density, a user can select N on a block boundary of the memory array, and configures the bit-widths of the bus 214 coupled between the bit mapping circuit 210 and the register 220, bus 224 coupled between the register 220 and the data converter 230, and bus 234 coupled between the data converter 230 and the multiplexer 240 to provide the desired N bits/cell. In still other embodiments of the invention, the bit mapping and data conversion circuit does not need to be configurable.

The specific embodiments previously described have been provided by way of example, and is not intended to limit the scope of the present invention. Modifications can be made to the previous embodiment and remain within the scope of the present invention. For example, in other embodiments of the invention, the bit mapping and data conversion circuit 130 can include registers having greater or lesser bit capacity that than described with reference to Figure 5. Additionally, the coupling of data converters to bit register locations and the bit-widths of the buses may be different in other embodiments as well. Therefore, those ordinarily skilled in the art will understand the previously described embodiments are not intended to limit the scope of the present invention.

Figure 8 illustrates a memory system 400 that includes a data path according an embodiment of the invention. The memory system 400 includes an array 430 of memory cells arranged in banks of rows and columns. In one embodiment, the memory cells of the array 430 are non-volatile memory. In some embodiments, the non-volatile memory cells are capable of storing multiple memory states, including non-volatile memory cells capable of storing a non-power-of-two number of memory states.

Most command signals, the address signals and the write data signals are applied to the memory system 400 as sets of sequential input/output ("I/O") signals transmitted through an I/O bus 434. The I/O bus 134 illustrated in Figure 8 may include I/O terminals 106 and I/O latch 110 (not shown in Figure 8). Similarly, read data signals are output from the memory system 400 through the I/O bus 434. The I/O bus is connected to an I/O control unit 440 that routes the signals between the I/O bus 434 and an internal data bus 442, an internal address bus 444, and an internal command bus 446. The internal data bus 442 may include a data path according to an embodiment of the present invention. A bit mapping and data conversion circuit 130 according to an embodiment of the present invention is coupled to the internal data bus 442. As previously discussed, the bit mapping and data conversion circuit 130 may be used to read and write data in multi-level memory cells storing a non-power-of-two number of memory states. The memory system 400 also includes a control logic unit 450 that receives a number of control signals either externally or through the command bus 446 to control the operation of the memory system 400. The address bus 444 applies row address signals to a row decoder 460 and column address signals to a column decoder 464. Similarly, the column decoder 464 enables write data signals to be applied to bit lines for columns corresponding to the column address signals and allow read data signals to be coupled from bit lines for columns corresponding to the column address signals.

In response to the memory commands decoded by the control logic unit 450, the memory cells in the array 430 are erased, programmed, or read. The memory array 430 is programmed on a row-by-row or page-by-page basis. After the row address signals have been applied to the address bus 444, the I/O control unit 440 routes write data through the bit mapping and data conversion circuit 130 to a cache register 470. The intermediate binary data are stored in the cache register 470 in preparation for programming. The cache register 470 sequentially stores the sets of intermediate binary data for an entire row or page of memory cells in the array 430. A page buffer (not shown), as previously described, may be included in or represented by the cache register 470 illustrated in Figure 8. Sense amplifiers previously discussed are not shown in Figure 8, although those ordinarily skilled in the art understand the memory system 400 includes sense amplifiers coupled to the memory cells of the array 430. All of the stored intermediate binary data are then used to program a row or page of memory cells in the array 430 selected by the row address coupled through the address bus 444. In a similar manner, during a read operation, intermediate binary data from a row or page of memory cells selected by the row address coupled through the address bus 444 are stored in a data register 480. Sets of the intermediate binary data are then transferred to the bit mapping and data conversion circuit 130 to provide read data to the I/O control unit 440 and then to the I/O bus 434.

From the foregoing it will be appreciated that, although specific embodiments of the invention have been described herein for purposes of illustration, various modifications may be made without deviating from the scope of the invention. The protection is given by the appended claims.

## Claims

1. A memory, comprising:
an array of memory cells (120), each of the cells configured to store a plurality of memory states and each memory cell configured to store a non-power-of-two number of memory states; and
a bit conversion circuit (130) coupled to the array of memory cells (120), the bit conversion circuit (130) configured to map and convert bits of binary user data into intermediate binary data corresponding to a respective memory state;
wherein the bit conversion (130) circuit comprises:
a bit mapping circuit (210) configured to map bits of the binary user data to provide mapped bits of the binary user data; and
a data converter circuit (230) coupled to the bit mapping circuit and configured to receive the mapped bits of the binary user data and convert the mapped bits of the binary user data into intermediate binary data corresponding to a memory state to be stored by a plurality of memory cells of the array (120), wherein the bit mapping circuit and the data converter circuit are configurable for use with different combinations of memory states to provide different bit/cell storage densities.

2. The memory of claim 1 wherein the bit mapping circuit and the data converter circuit are user configurable for use with different combinations of memory states to provide different bit/cell storage densities.

3. The memory of claim 1 wherein the bit mapping circuit (210) is configured to map bits of the binary user data to sub-groups of bits, the sub-groups having fewer bits than a byte of the binary user data.

4. The memory of claim 3 wherein the data converter circuit (230) comprises a plurality of data converter subcircuits, each of the data converter subcircuits coupled to receive the bits of a respective sub-group of bits.

5. The memory of claim 1 wherein the memory state is included in a plurality of memory states to be stored by a respective one of the plurality of memory cells, and
wherein the mapped bits of the binary user data are each converted by the data converter circuit (230) into intermediate binary data corresponding to the plurality of memory states to be stored by the respective one of the plurality of memory cells.

6. A method for storing data in memory cells of a memory, said memory comprising a memory array (120) and a bit conversion circuit (130), wherein the bit conversion circuit comprises a bit mapping circuit (210) and a data converter circuit (230), wherein the bit mapping circuit and the data converter circuit are configurable for use with different combinations of memory states to provide different bit/cell storage densities, the method comprising:
mapping bits of binary user data to provide mapped bits of the binary user data;
converting the mapped bits of the binary user data into intermediate binary data corresponding to a memory state; and
storing the memory state in a plurality of memory cells corresponding to the intermediate binary data, wherein each of the cells is configured to store a plurality of memory states and each memory cell is configured to store a non-power-of-two number of memory states.

7. The method of claim 6 wherein the mapping bits of the binary user data comprises dividing the binary user data into at least one sub-group of bits, and
wherein the converting the mapped bits of the binary user data into intermediate binary data comprises converting the at least one sub-group of bits into corresponding intermediate binary data.

8. The method of claim 7 wherein converting the at least one sub-group of bits into corresponding intermediate binary data comprises converting the at least one sub-group of bits into a plurality of intermediate binary data and wherein storing a memory state corresponding to the intermediate binary data comprises storing in a respective plurality of memory cells a memory state corresponding to the respective intermediate binary data.

9. The method of claim 6, further comprising reading data from the memory cells of the memory array (120), the data read by;
sensing memory states stored by memory cells and determining a respective corresponding intermediate binary data therefrom;
converting the intermediate binary data into a corresponding sub-groups of bits; mapping the sub-groups of bits to binary user data; and
providing the binary user data as read data.

10. The method of claim 6 wherein storing the memory state in the plurality of memory cells comprises:
when the binary user data is stored to the array of memory cells (120), mapping bits of the binary user data to provide groups of bits including the mapped bits of the binary user data, converting the groups of bits of the binary user data into corresponding intermediate binary data and storing a memory state in the plurality of memory cells corresponding to the intermediate binary data; and
when the binary user data is read from the array of memory cells, sensing the memory state stored in the plurality of memory cells and generating the intermediate binary data, converting the intermediate binary data to corresponding groups of bits of the groups of bits including the mapped bits of the binary user data, and mapping the groups of bits to bits of the binary user data.

11. The method of claim 10 wherein converting the intermediate binary data to the corresponding groups of bits comprises converting a plurality of intermediate binary data for each of the corresponding groups of bits.

## Patentansprüche

1. Speicher, umfassend:
eine Anordnung von Speicherzellen (120), wobei jede der Zellen konfiguriert ist zum Speichern einer Vielzahl von Speicherzuständen und wobei jede Speicherzelle konfiguriert ist zum Speichern einer Nicht-Zweierpotenz-Anzahl von Speicherzuständen; und
einen Bitumwandlungsschaltkreis (130), der mit der Anordnung von Speicherzellen (120) verbunden ist, wobei der Bitumwandlungsschaltkreis (130) konfiguriert ist zum Zuordnen und Umwandeln von Bits von binären Benutzerdaten in binäre Zwischendaten, die einem entsprechenden Speicherzustand entsprechen;
wobei der Bitumwandlungsschaltkreis (130) umfasst:
einen Bitzuordnungsschaltkreis (210), der konfiguriert ist zum Zuordnen von Bits der binären Benutzerdaten, um zugeordnete Bits der binären Benutzerdaten bereitzustellen; und
einen Datenwandlerschaltkreis (230), der mit dem Bitzuordnungsschaltkreis verbunden ist und konfiguriert ist zum Empfangen der zugeordneten Bits der binären Benutzerdaten und zum Umwandeln der zugeordneten Bits der binären Benutzerdaten in binäre Zwischendaten, die einem Speicherzustand entsprechen, der in einer Vielzahl von Speicherzellen der Anordnung (120) gespeichert wird, wobei der Bitzuordnungsschaltkreis und der Datenwandlerschaltkreis für eine Verwendung mit unterschiedlichen Kombinationen von Speicherzuständen konfigurierbar sind, um unterschiedliche Bit-/Zellenspeicherdichten bereitzustellen.

2. Speicher nach Anspruch 1, wobei der Bitzuordnungsschaltkreis und der Datenwandlerschaltkreis für eine Verwendung mit unterschiedlichen Kombinationen von Speicherzuständen benutzerkonfigurierbar sind, um unterschiedliche Bit-/Zellenspeicherdichten bereitzustellen.

3. Speicher nach Anspruch 1, wobei der Bitzuordnungsschaltkreis (210) konfiguriert ist zum Zuordnen von Bits der binären Benutzerdaten zu Untergruppen von Bits, wobei die Untergruppen weniger Bits als ein Byte der binären Benutzerdaten aufweisen.

4. Speicher nach Anspruch 3, wobei der Datenwandlerschaltkreis (230) eine Vielzahl von Datenwandlerunterschaltkreisen umfasst, wobei jeder Datenwandlerunterschaltkreis angeschlossen ist, um die Bits einer entsprechenden Untergruppe von Bits zu empfangen.

5. Speicher nach Anspruch 1, wobei der Speicherzustand in einer Vielzahl von Speicherzuständen enthalten ist, die in einer entsprechenden aus der Vielzahl von Speicherzellen gespeichert wird, und
wobei die zugeordneten Bits der binären Benutzerdaten jeweils durch den Datenwandlerschaltkreis (230) in binäre Zwischendaten umgewandelt werden, die der Vielzahl von Speicherzuständen entsprechen, die in der entsprechenden aus der Vielzahl von Speicherzellen gespeichert wird.

6. Verfahren zum Speichern von Daten in Speicherzellen eines Speichers, wobei der Speicher eine Speicheranordnung (120) und einen Bitumwandlungsschaltkreis (130) umfasst, wobei der Bitumwandlungsschaltkreis einen Bitzuordnungsschaltkreis (210) und einen Datenwandlerschaltkreis (230) umfasst, wobei der Bitzuordnungsschaltkreis und der Datenwandlerschaltkreis für eine Verwendung mit unterschiedlichen Kombinationen von Speicherzuständen konfigurierbar sind, um unterschiedliche Bit-/Zellenspeicherdichten bereitzustellen, wobei das Verfahren umfasst:
Zuordnen von Bits von binären Benutzerdaten, um zugeordnete Bits der binären Benutzerdaten bereitzustellen;
Umwandeln der zugeordneten Bits der binären Benutzerdaten in binäre Zwischendaten, die einem Speicherzustand entsprechen; und
Speichern des Speicherzustands in einer Vielzahl von Speicherzellen, der den binären Zwischendaten entspricht, wobei jede der Zellen konfiguriert ist zum Speichern einer Vielzahl von Speicherzuständen und wobei jede Speicherzelle konfiguriert ist zum Speichern einer Nicht-Zweierpotenz-Anzahl von Speicherzuständen.

7. Verfahren nach Anspruch 6, wobei das Zuordnen von Bits der binären Benutzerdaten ein Teilen der binären Benutzerdaten in mindestens eine Untergruppe von Bits umfasst, und
wobei das Umwandeln der zugeordneten Bits der binären Benutzerdaten in binäre Zwischendaten ein Umwandeln der mindestens einen Untergruppe von Bits in entsprechende binäre Zwischendaten umfasst.

8. Verfahren nach Anspruch 7, wobei das Umwandeln der mindestens einen Untergruppe von Bits in entsprechende binäre Zwischendaten ein Umwandeln der mindestens einen Untergruppe von Bits in eine Vielzahl von binären Zwischendaten umfasst, und wobei das Speichern eines Speicherzustands, der den binären Zwischendaten entspricht, ein Speichern eines Speicherzustands, der den entsprechenden binären Zwischendaten entspricht, in eine entsprechende Vielzahl von Speicherzellen umfasst.

9. Verfahren nach Anspruch 6, das außerdem ein Lesen von Daten aus den Speicherzellen der Speicheranordnung (120) umfasst, wobei die Daten gelesen werden, indem:
Speicherzustände erfasst werden, die in den Speicherzellen gespeichert sind, und daraus jeweilige entsprechende binäre Zwischendaten ermittelt werden;
die binären Benutzerdaten in entsprechende Untergruppen von Bits umgewandelt werden;
die Untergruppen von Bits zu den binären Benutzerdaten zugeordnet werden; und
die binären Benutzerdaten als Lesedaten bereitgestellt werden.

10. Verfahren nach Anspruch 6, wobei das Speichern des Speicherzustands in der Vielzahl von Speicherzellen umfasst:
wenn die binären Benutzerdaten in der Anordnung von Speicherzellen (120) gespeichert werden, Zuordnen von Bits der binären Benutzerdaten, um Gruppen von Bits bereitzustellen, welche die zugeordneten Bits der binären Benutzerdaten enthalten, Umwandeln der Gruppen von Bits der binären Benutzerdaten in entsprechende binäre Zwischendaten und Speichern eines Speicherzustands, der den binären Zwischendaten entspricht, in der Vielzahl von Speicherzellen, und
wenn die binären Benutzerdaten aus der Anordnung von Speicherzellen gelesen werden, Erfassen des Speicherzustands, der in der Vielzahl von Speicherzellen gespeichert ist, und Erzeugen der binären Zwischendaten, Umwandeln der binären Zwischendaten in entsprechende Gruppen von Bits der Gruppen von Bits, welche die zugeordneten Bits der binären Benutzerdaten enthalten, und Zuordnen der Gruppen von Bits zu Bits der binären Benutzerdaten.

11. Verfahren nach Anspruch 10, wobei das Umwandeln der binären Zwischendaten in die entsprechenden Gruppen von Bits ein Umwandeln einer Vielzahl von binären Zwischendaten für jede der entsprechenden Gruppen von Bits umfasst.

## Revendications

1. Mémoire, comprenant :
une matrice de cellules de mémoire (120), chacune des cellules étant configurée pour mémoriser une pluralité d'états de mémoire et chaque cellule de mémoire étant configurée pour mémoriser un nombre non de puissance de deux d'états de mémoire ; et
un circuit de conversion de bits (130) couplé à la matrice de cellules de mémoire (120), le circuit de conversion de bits (130) étant configuré pour mapper et convertir des bits de données d'utilisateur binaires en données binaires intermédiaires correspondant à un état de mémoire respectif ;
dans lequel le circuit de conversion de bits (130) comprend :
un circuit de mappage de bits (210) configuré pour mapper des bits des données d'utilisateur binaires afin de fournir des bits mappés des données d'utilisateur binaires ; et
un circuit de conversion de données (230) couplé au circuit de mappage de bits et configuré pour recevoir les bits mappés des données d'utilisateur binaires et convertir les bits mappés des données d'utilisateur binaires en données binaires intermédiaires correspondant à un état de mémoire devant être mémorisé par une pluralité de cellules de mémoire de la matrice (120), le circuit de mappage de bits et le circuit de conversion de données étant configurables pour leur utilisation avec différentes combinaisons d'états de mémoire afin de fournir différentes densités de mémorisation bits/cellules.

2. Mémoire selon la revendication 1 dans laquelle le circuit de mappage de bits et le circuit de conversion de données sont configurables par l'utilisateur pour leur utilisation avec différentes combinaisons d'états de mémoire pour fournir différentes densités de mémorisation bits/cellules.

3. Mémoire selon la revendication 1 dans laquelle le circuit de mappage de bits (210) est configuré pour mapper des bits des données d'utilisateur binaires sur des sous-groupes de bits, les sous-groupes comportant moins de bits qu'un octet des données d'utilisateur binaires.

4. Mémoire selon la revendication 3 dans laquelle le circuit de conversion de données (230) comprend une pluralité de sous-circuits de conversion de données, chaque sous-circuit de conversion de données étant couplé pour recevoir les bits d'un sous-groupe de bits respectif.

5. Mémoire selon la revendication 1 dans laquelle l'état de mémoire est inclus dans une pluralité d'états de mémoire devant être mémorisés par une cellule respective de la pluralité de cellules de mémoire, et
dans laquelle les bits mappés des données d'utilisateur binaires sont chacun convertis par le circuit de conversion de données (230) en données binaires intermédiaires correspondant à la pluralité d'états de mémoire devant être mémorisés par la cellule respective de la pluralité de cellules de mémoire.

6. Procédé de mémorisation de données dans des cellules de mémoire d'une mémoire, ladite mémoire comprenant une matrice de mémoire (120) et un circuit de conversion de bits (130), le circuit de conversion de bits comprenant un circuit de mappage de bits (210) et un circuit de conversion de données (230), le circuit de mappage de bits et le circuit de conversion de données étant configurables pour leur utilisation avec différentes combinaisons d'états de mémoire pour fournir différentes densités de mémorisation bits/cellules, le procédé comprenant :
le mappage de bits de données d'utilisateur binaires pour fournir des bits mappés des données d'utilisateur binaires ;
la conversion des bits mappés des données d'utilisateur binaires en données binaires intermédiaires correspondant à un état de mémoire ; et
la mémorisation de l'état de mémoire dans une pluralité de cellules de mémoire correspondant aux données binaires intermédiaires, chacune des cellules étant configurée pour mémoriser une pluralité d'états de mémoire et chaque cellule de mémoire étant configurée pour mémoriser un nombre non de puissance de deux d'états de mémoire.

7. Procédé selon la revendication 6 dans lequel le mappage des bits des données d'utilisateur binaires comprend la division des données d'utilisateur binaires en au moins un sous-groupe de bits, et
dans lequel la conversion des bits mappés des données d'utilisateur binaires en données binaires intermédiaires comprend la conversion de l'au moins un sous-groupe de bits en données binaires intermédiaires correspondantes.

8. Procédé selon la revendication 7 dans lequel la conversion de l'au moins un sous-groupe de bits en données binaires intermédiaires correspondantes comprend la conversion de l'au moins un sous-groupe de bits en une pluralité de données binaires intermédiaires et la mémorisation d'un état de mémoire correspondant aux données binaires intermédiaires comprend la mémorisation dans une pluralité respective de cellules de mémoire d'un état de mémoire correspondant aux données binaires intermédiaires respectives.

9. Procédé selon la revendication 6, comprenant en outre la lecture de données à partir des cellules de mémoire de la matrice de mémoire (120), les données étant lues en :
détectant des états de mémoire mémorisés par des cellules de mémoire et déterminant à partir de ceux-ci des données binaires intermédiaires correspondantes respectives ;
convertissant les données binaires intermédiaires en sous-groupes de bits correspondants ;
mappant les sous-groupes de bits sur des données d'utilisateur binaires ; et
fournissant les données d'utilisateur binaires en tant que données lues.

10. Procédé selon la revendication 6 dans lequel la mémorisation de l'état de mémoire dans la pluralité de cellules de mémoire comprend :
quand les données d'utilisateur binaires sont mémorisées dans la matrice de cellules de mémoire (120), le mappage de bits des données d'utilisateur binaires pour fournir des groupes de bits comportant les bits mappés des données d'utilisateur binaires, la conversion des groupes de bits des données d'utilisateur binaires en données binaires intermédiaires correspondantes et la mémorisation d'un état de mémoire dans la pluralité de cellules de mémoire correspondant aux données binaires intermédiaires ; et
quand les données d'utilisateur binaires sons lues à partir de la matrice de cellules de mémoire, la détection de l'état de mémoire mémorisé dans la pluralité de cellules de mémoire et la génération des données binaires intermédiaires, la conversion des données binaires intermédiaires en groupes correspondants de bits des groupes de bits comportant les bits mappés des données d'utilisateur binaires, et le mappage des groupes de bits sur des bits des données d'utilisateur binaires.

11. Procédé selon la revendication 10 dans laquelle la conversion des données binaires intermédiaires en groupes correspondants de bits comprend la conversion d'une pluralité de données binaires intermédiaires pour chacun des groupes de bits correspondants.
